# EUROPEAN PATENT APPLICATION

(11) **EP 1 325 969 A2**
(43) Date of publication of application: **09.07.2003**
(21) Application number: 02258686.1
(22) Date of filing: 17.12.2002
(51) Int. Cl.: C23C 14/32, H01L 21/768

(54) **Ion plating method and system for forming a wiring on a semiconductor device**

(30) Priority: 17.12.2001 JP 2001383534
(71) Applicant: Shinmaywa Industries, Ltd., Takarazuka-shi, Hyogo 665-8550 (JP); Tsukuba Semi Technology, Tsukuba-shi, Ibaragi 305-0031 (JP); Nissei Electronics, Ltd., Minato-ku, Tokyo 105-8418 (JP)
(72) Inventor: Marunaka, Masao, Takarazuka-shi, Hyogo 665-8550 (JP); Doi, Toshiya, Takarazuka-shi, Hyogo 665-8550 (JP); Nose, Kouichi, Takarazuka-shi, Hyogo 665-8550 (JP); Takigawa, Shirou, Takarazuka-shi, Hyogo 665-8550 (JP); Otake, Kiyoshi, Tsukuba-shi, Ibaragi 305-0031 (JP)
(74) Representative: Abbie, Andrew Kenneth

(57) **Abstract**

In an ion plating system, a wafer (201) ion which a semiconductor wiring film of e.g. Cu is to be formed is held by a wafer substrate holder (3) disposed in a vacuum chamber (2); the material of the semiconductor wiring film is evaporated by an evaporation source (4) disposed in the vacuum chamber; and a high frequency electric power for generating a plasma in the vacuum chamber, making use of the substrate holder as an electrode is supplied from a high frequency power source (10).

## Description

### Background of the Invention

### 1. Field of the Invention

The present invention relates to a method and system of forming semiconductor wiring, a method and system of fabricating a semiconductor device, and a wafer. More particularly, the invention relates to wiring formation in which wiring is formed so as to be embedded in grooves defined in a wafer.

### 2. Description of the Related Art

In the field of VLSI, the wiring forming method called "damascene process" has been well known. In the damascene process, wiring grooves, contact holes, through holes (via holes) and others are formed in an interlayer insulating film and then, they are filled with copper thereby forming a wiring system embedded in the interlayer insulating film. With this technique, ICs having a flat surface free from steps in the wiring can be produced and highly reliable, low-resistance metal wiring systems can be achieved.

Generally, the damascene process utilizes wet plating techniques for filling the wiring grooves etc. of the interlayer insulating film with copper. Wet plating is advantageous in that wiring grooves having a high aspect ratio can be filled with copper.

Wet plating, however, requires a seed film which, per se, is formed by other film deposition methods than wet plating and therefore, as the aspect ratio of a wiring trench increases, it becomes difficult to uniformly form the seed film in the wiring trench. If the seed film is non-uniform, thin parts of the film are melted and vanished by a plating current so that voids tend to be created. That is, in wet plating, as the aspect ratio increases, voids are more likely to be created. In the damascene process, the surface of the wafer is smoothed by CMP (chemical and mechanical polishing), subsequent to filling the wire grooves etc. with copper. However, the copper film formed by wet plating is too soft to directly polish and, therefore, polishing is carried out after curing the film by heat treatment and alleviating the steps on the surface of the film by reflow. This disadvantageously involves an excessive number of man hours. In the damascene process, a barrier layer is formed for preventing diffusion of copper into the interlayer insulating film, and this barrier layer is preferably narrow in width in order to reduce wiring resistance in wiring grooves which have a high aspect ratio and therefore narrow width. Wet plating however requires certain width and has the possibility that environmental contamination may be caused by waste solution.

Japanese Patent Publication (*KOKAI*) No. 2000-64028 discloses a copper film deposition method for filling grooves having a high aspect ratio with a wiring material through a dry process, utilizing ion plating in which an evaporative substance constituted by copper is evaporated by a plasma beam. Since this Cu film deposition technique is a dry process, it is thought that environmental pollution nor void creation which is a phenomenon inherent to wet plating is not caused.

However, since the energy of the evaporated substance (i.e., copper) in the copper film deposition method is almost the same as that of spattering, a remarkable improvement in the hardness of the copper film to be deposited on the wafer cannot be expected and therefore it remains uncertain whether or not the copper film deposition method can obviate the need for the thermal curing process and the surface planarization process by reflow and reduce the thickness of the barrier layer. In addition, the copper film deposition method carries out ionization of the evaporated substance by use of the plasma beam which is commonly used for evaporating the evaporative substance, so that the ionization of the evaporated substance cannot be controlled independently of the evaporation of the evaporative substance and, as a result, the film deposition cannot be always performed under the optimum condition.

### Summary of the Invention

The invention is directed to overcoming the foregoing shortcomings and a primary object of the invention is therefore to provide a method and system of forming semiconductor wiring, a method and system of fabricating a semiconductor device, and a wafer, which enable omission of the thermal curing process and the surface planarization process; a reduction in the thickness of the barrier layer; and formation of wiring in grooves having a high aspect ratio under the optimum condition.

This object can be accomplished by a method and system of forming semiconductor wiring according to the invention,
wherein a vacuum chamber the inside of which can be maintained in a substantially vacuum condition is used;
wherein a wafer on which a semiconductor wiring film is to be formed is held by a substrate holder disposed in the vacuum chamber;
wherein the material of the semiconductor wiring film is evaporated by an evaporation source disposed within the vacuum chamber; and
wherein a high frequency power source supplies a high frequency electric power for generating a plasma in the vacuum chamber, making use of the substrate holder as an electrode (Claims 1 and 17). With this arrangement, the semiconductor wiring film material evaporated from the evaporation source is energized by the plasma and significantly accelerated by the self-bias generated by the high frequency electric field developed within the vacuum chamber so that the material comes into collision with the surface of the wafer, depositing thereon. Accordingly, the resulting semiconductor wiring film formed on the wafer has good density and adhesion. In consequence, omission of the thermal curing process and the surface planarization process for the semiconductor wiring film and a reduction in the thickness of the barrier layer become possible. In addition, the rectilinear elongation property of the semiconductor wiring film material which has evaporated becomes good, and the generating condition of the plasma within the vacuum chamber can be independently controlled. Therefore, even if wiring grooves having an aspect ratio higher than those of the prior art are formed in the wafer, the grooves can be filled with the semiconductor wiring film material in a good condition.

In this case, a gas containing hydrogen or an OH group may be supplied to the vacuum chamber (Claims 2 and 18). This enables it to give the migration effect to the semiconductor wiring film material energized by the plasma, so that the semiconductor wiring film to be formed on the wafer can be made to have good density and low resistance.

In this case, the hydrogen content of the atmosphere within the vacuum chamber may be 4 to 20 % by volume (Claim 19). This makes it possible to effectively obtain the migration effect.

A d.c. electric field may be created in the vacuum chamber by a d.c. power source, using the substrate holder as a negative electrode (Claims 3 and 20). With this arrangement, the semiconductor material which has been energized by the plasma can be further accelerated by the d.c. power source, so that the rectilinear elongation property of the semiconductor material can be more improved and the grooves of the wafer can be filled with the semiconductor wiring film material in a better condition.

The forming condition of the semiconductor wiring film may be controlled based on the result of monitoring the depositing condition of the semiconductor wiring film being formed on the wafer (Claims 4 and 21). This enables desirable control of the deposition curve of the semiconductor wiring film. As a result, the semiconductor wiring film can be formed so as to have the optimum deposition curve.

In this case, the forming condition of the semiconductor wiring film may be at least one of the deposition rate of the semiconductor wiring film, the level of the high frequency electric power and the magnitude of the d.c. electric field (Claims 5 and 22). This makes it possible to properly deposit the semiconductor wiring film material on the wafer.

The potential of the substrate holder may be temporarily changed to a positive potential (Claims 6 and 23). Where the semiconductor wiring film is to be formed on an insulating material, the ionized semiconductor wiring film material is likely to be deposited in conical form with its ions repelling each other. With the above arrangement, the direction of the electric field in the vicinity of the wafer is temporarily reversed and the semiconductor wiring film material which has been once deposited is separated from the surface of the wafer and then adheres to the wafer surface again. At that time, the ions of the semiconductor wiring film material align again such that the material is deposited in layers substantially parallel with the surface of the wafer. Consequently, a more dense semiconductor wiring film can be attained.

The potential of the substrate holder may be temporarily changed to a positive potential by superimposing a pulse on the d.c. electric field, the pulse reversing the direction of the d.c. electric field in a predetermined cycle over a specified period of time (Claims 7 and 24).

The semiconductor wiring film material evaporated from the evaporation source may be supplied by semiconductor wiring film material feeding means which can continuously feed the semiconductor wiring film material for 24 hours or more (Claims 8 and 25). This eliminates the major bottleneck of continuous film deposition, by enabling continuous feeding of the semiconductor wiring film material (evaporative material) for 24 hours or more and therefore enables continuous operation for 24 hours or more which is required for the deposition of the semiconductor wiring film material on the wafer.

The evaporation source and the semiconductor wiring film material feeding means may be comprised of at least one of or a combination of techniques which are (1) a technique utilizing electron beam heating and a rotary-revolutionary multi-point crucible in combination; (2) a technique utilizing electron beam heating and an automatic wire-like semiconductor wiring film material feeding mechanism in combination; (3) a technique utilizing electron beam heating and an automatic pellet-like semiconductor wiring film material feeding mechanism in combination; (4) a technique utilizing resistive heating and a rotary-revolutionary multi-point boat in combination; (5) a technique utilizing resistive heating and an automatic wire-like semiconductor wiring film material feeding mechanism in combination; (6) a technique utilizing resistive heating and an automatic pellet-like semiconductor wiring film material feeding mechanism in combination; (7) arcing with an automatic semiconductor wiring film material feeding mechanism; (8) ion beam irradiation; and (9) DC spattering (Claims 9 and 26). This easily actualizes an evaporation source and semiconductor wiring film material feeding means which are capable of continuously feeding the semiconductor wiring film material for 24 hours or more.

The semiconductor wiring film material evaporated from the evaporation source may be quantitatively supplied (Claims 10 and 27). This enables accurate control of the thickness of the semiconductor wiring film to be formed on the wafer.

In addition, the gas pressure of the substantially vacuum condition may be in the order of 10⁻³ Pa (Claims 11 and 28). This enables grooves having a high aspect ratio to be properly filled with the semiconductor wiring film material.

A matching unit for matching the impedance of the power source side to the impedance of the load side and a capacitor having specified capacitance are inserted in a circuit for supplying the high frequency electric power such that they are connected in series with the other electrode for supplying the high frequency electric power and the substrate holder (Claims 12 and 29). With this arrangement, a plasma can be stably generated by the high frequency electric power within the vacuum chamber.

The semiconductor wiring film to be formed on the surface of the wafer held by the substrate holder may be irradiated with an energy beam (Claims 13 and 30). With this arrangement, the energy of the semiconductor wiring film to be formed on the surface of the wafer is enhanced, with its molecules being aligned without gaps so that the density of the semiconductor wiring film is further increased.

The other electrode for supplying the high frequency electric power may be the vacuum chamber comprised of a conductive element (Claims 14 and 31). This allows a comparatively wide distribution of plasma within the vacuum chamber so that the coverage of the semiconductor wiring film material with respect to the surface of the wafer is improved.

Wiring grooves may be formed on the surface of the wafer and the semiconductor wiring film material may be copper (Claims 15 and 32). This enables it to form a copper wiring film in the grooves formed in the wafer and having a higher aspect ratio than the prior art.

In addition, the semiconductor wiring forming method of the invention may comprise the steps of forming a seed film on a wafer by the semiconductor wiring forming method of Claim 17 and forming a semiconductor wiring film on the wafer from the seed film by wet plating (Claim 33). With this arrangement, when the seed film is formed, a cloud of plasma is generated so as to enclose the surface of the wafer, so that the coverage of the evaporative material with respect to the surface of the wafer is improved and therefore the seed film has good step coverage. In consequence, copper wiring to be formed by wet plating has good step coverage, leading to a reduction in the number of voids to be created in the copper wiring.

In this case, a barrier layer may be formed as an underlayer for the seed film and copper may be used as the material of the seed film and the semiconductor wiring film (Claim 34). With this arrangement, the seed film and the barrier layer become dense and hard, so that the copper of the seed film is unlikely to disperse into the barrier layer and at the same time, the copper dispersion blocking function of the barrier layer is improved. By virtue of these effects in combination, the barrier layer can be thinned compared to the prior art. As a result, wiring resistance can be reduced to a degree corresponding to the reduction in the thickness of the barrier layer.

According to the invention, there are provided a method and system of fabricating a semiconductor device,
wherein at least a transfer chamber and a load lock chamber, a barrier chamber, a copper film deposition chamber and an unload chamber which are respectively connected to the transfer chamber through gates are used;
which includes the step of placing a wafer in the unload chamber after the wafer placed in the load lock chamber has been transferred sequentially to the barrier chamber and the copper film deposition chamber by transfer means disposed in the transfer chamber, with the gates being opened and closed to apply specified treatments to the wafer, and
wherein the specified treatment carried out in the copper film deposition chamber is constituted by the semiconductor wiring forming method of claim 32 or the copper film deposition chamber is constituted by the semiconductor wiring forming system of claim 15 (Claims 16 and 35). With this arrangement, copper wiring can be properly formed on the wafer by a dry process.

According to the invention, there is provided a wafer wherein grooves having a width of about 0.35µm and depth of about 1µm are formed on the surface of the wafer or on the surface of a layer formed on the wafer and substantially 100 per cent of the grooves is filled with a wiring film material comprised of copper by a dry process (Claim 36). This provides semiconductor device wiring having high density and relatively low resistance.

The above and further objects and features of the invention will be more fully apparent from the following detailed description with accompanying drawings.

### Brief Description of the Drawings

Figure 1 is a pattern diagram showing a configuration of a semiconductor wiring forming system according to a first embodiment of the invention.
Figure 2 is a waveform chart showing a waveform of a bias voltage in the semiconductor wiring forming system shown in Figure 1.
Figure 3 is a pattern diagram showing a potential distribution between a substrate holder and an evaporation source in the semiconductor wiring forming system shown in Figure 1.
Figure 4 is a pattern diagram showing a configuration of the evaporation source and evaporative material feeding system of the semiconductor wiring forming system shown in Figure 1.
Figure 5 is a cross-sectional photograph showing a filling condition of wiring grooves formed in a wafer, the wiring grooves being filled with a wiring material by a semiconductor wiring forming method according to Example 1 of the first embodiment of the invention.
Figure 6 is a sketch of the cross-sectional photograph of Figure 5.
Figure 7 is a cross-sectional photograph showing a polished condition of the surface of a thin film formed on a wafer by a semiconductor wiring forming method according to Example 2 of the first embodiment of the invention.
Figure 8 is a perspective view diagrammatically showing a configuration of a first modification of the evaporation source and evaporative material feeding system of the first embodiment of the invention.
Figure 9 is a perspective view diagrammatically showing a configuration of a second modification of the evaporation source and evaporative material feeding system of the first embodiment of the invention.
Figure 10 is a perspective view diagrammatically showing a configuration of a third modification of the evaporation source and evaporative material feeding system of the first embodiment of the invention.
Figure 11 is a perspective view diagrammatically showing a configuration of a fourth modification of the evaporation source and evaporative material feeding system of the first embodiment of the invention.
Figure 12 is a sectional view diagrammatically showing a configuration of a fifth modification of the evaporation source and evaporative material feeding system of the first embodiment of the invention.
Figure 13 is a pattern diagram diagrammatically showing a configuration of a sixth modification of the evaporation source and evaporative material feeding system of the first embodiment of the invention.
Figure 14 is a perspective view diagrammatically showing a configuration of a seventh modification of the evaporation source and evaporative material feeding system of the first embodiment of the invention.
Figure 15 is a plan view diagrammatically showing a configuration of a semiconductor device fabricating system according to a second embodiment of the invention.
Figure 16 is a plan view diagrammatically showing a configuration of a modification of the second embodiment of the invention.
Figure 17 is a process cross-sectional view showing a method of forming wiring for a semiconductor device.
Figure 18 is a cross-sectional photograph showing the coverage of a seed film formed on a wafer by a semiconductor wiring forming method according to a third embodiment of the invention.
Figure 19 is a sketch of the photograph of Figure 18.
Figure 20 is a pattern diagram showing a configuration of a semiconductor wiring forming system according to a fourth embodiment of the invention.

### Detailed Description of the Preferred Embodiments

Referring now to the accompanying drawings, preferred embodiments of the invention will be described below.

### First Embodiment

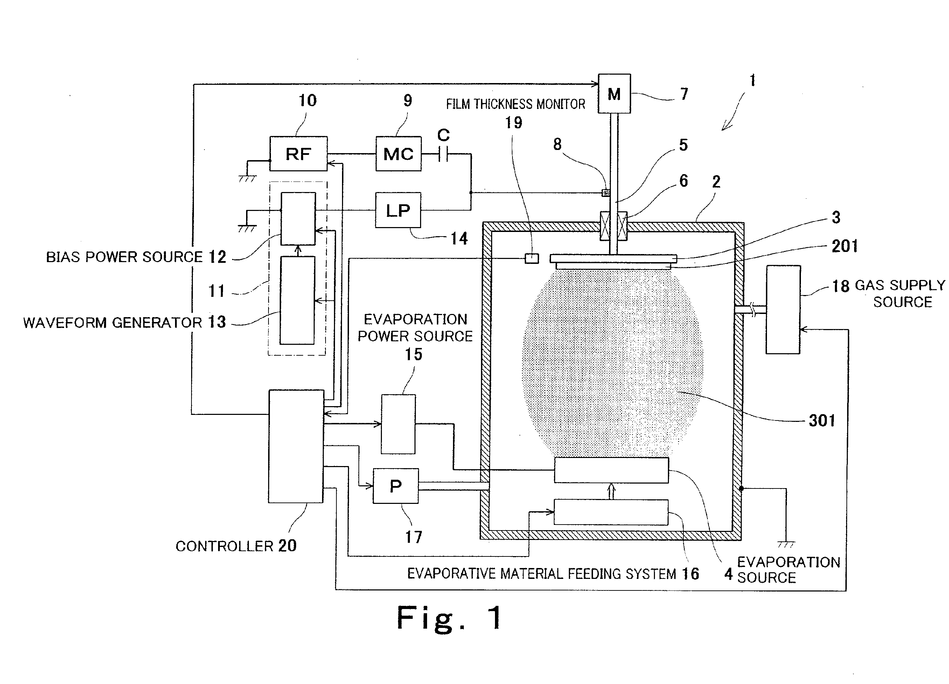

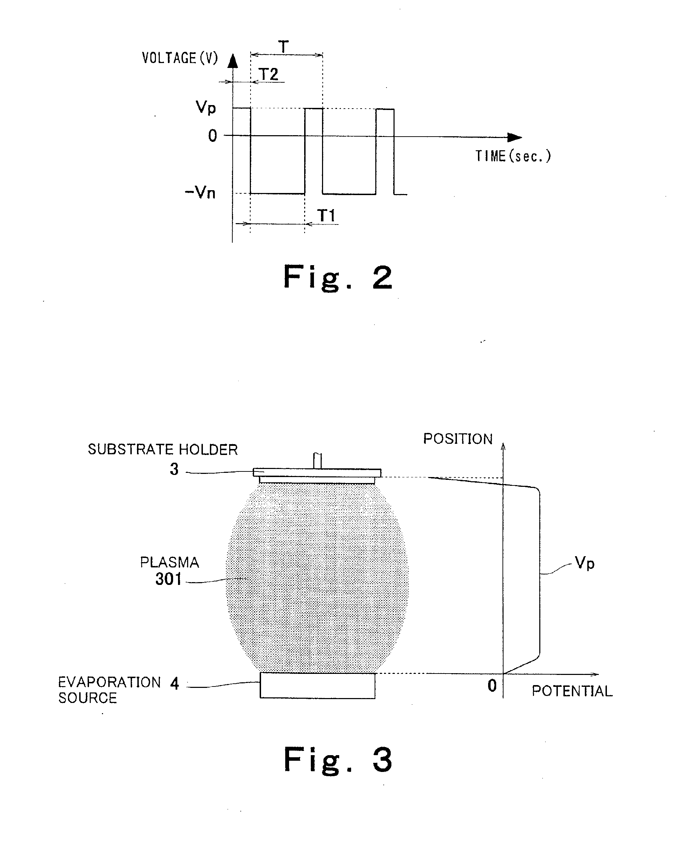

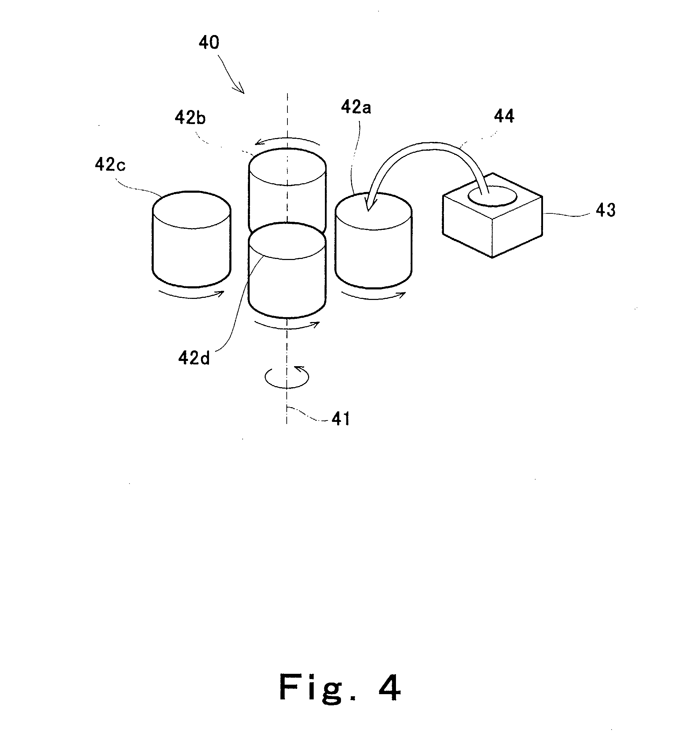

Figure 1 is a pattern diagram showing a configuration of a semiconductor wiring forming system according to a first embodiment of the invention; Figure 2 is a waveform chart showing a waveform of a bias voltage in the semiconductor wiring forming system shown in Figure 1; Figure 3 is a pattern diagram showing a potential distribution between a substrate holder and an evaporation source in the semiconductor wiring forming system shown in Figure 1; and Figure 4 is a pattern diagram showing a configuration of the evaporation source and evaporative material feeding system of the semiconductor wiring forming system shown in Figure 1.

In Figure 1, a semiconductor wiring forming system 1 according to the first embodiment is comprised of an ion plating system having a configuration well suited to formation of wiring on a wafer and includes a vacuum chamber 2. The vacuum chamber 2 is comprised of a conductive element, having a substrate holder 3 inside thereof for holding a wafer 201. The substrate holder 3 is formed from a conductive material and secured at its center to one end of a rotary shaft 5. The rotary shaft 5 is formed from a conductive material and pivotally mounted on a wall of the vacuum chamber 2 by a bearing 6. The other end of the rotary shaft 5 which projects outwardly from the vacuum chamber 2 is connected to the major axis of a motor 7. This allows the substrate holder 3 to be rotationally driven by the motor 7. Insulating elements (not shown) cut off connections between the bearing 6 and the vacuum chamber 2 and between the other end of the rotary shaft 5 and the major axis of the motor 7. One of the output terminals (not shown) of a high frequency power source 10 and one of the output terminals (not shown) of a bias power source unit 11 are respectively connected through a brush 8 to a part of the rotary shaft 5, the part being located outside the vacuum chamber 2. More specifically, the high frequency power source 10 and the bias power source unit 11 are connected in parallel, being connected to the brush 8. Inserted between the brush 8 and the high frequency power source 10 are a matching capacitor C and a matching unit 9 which are connected in series. Inserted between the brush 8 and the bias power source unit 11 is a low pass filter 14 for blocking high frequency. The other output terminals (not shown) of the high frequency power source 10 and the bias power source unit 11 are respectively grounded, thereby being connected to the vacuum chamber 2 that is also grounded. Thus, a high frequency plasma generation circuit is formed in which the substrate holder 3 and the vacuum chamber 2 serving as discharging electrodes are connected to the output terminal of the high frequency power source 10 through the matching unit 9 and the matching capacitor C. A bias circuit is formed for applying a specified bias voltage generated by the bias power source unit 11 between the substrate holder 3 and the vacuum chamber 2 serving as discharging electrodes through the low pass filter 14.

An evaporation source 4 is disposed within the vacuum chamber 2 so as to face the substrate holder 3, for evaporating the material (i.e., semiconductor wiring film material which is hereinafter referred to as "wiring material") of a wiring film to be formed on the wafer 201. The evaporation source 4 is connected to an evaporation power source 15 for supplying evaporation energy. The evaporation source 4 is supplied with the wiring material from an evaporative material feeding system (i.e., wiring material feeding means) 16. Although the evaporation power source 15 and the evaporative material feeding system 16 may be installed inside or outside the vacuum chamber 2, this embodiment is designed with the evaporation power source 15 being disposed outside the vacuum chamber 2 whereas the evaporative material feeding system 16 is disposed inside the vacuum chamber 2.

In the vicinity of the substrate holder 3 within the vacuum chamber 2, a film thickness monitor 19 is disposed.

A vacuum pump 17 and a gas supply source 18 are connected to the vacuum chamber 2, thereby maintaining the inside of the vacuum chamber 2 at a specified degree of vacuum and introducing a specified gas from the gas supply source 18 to the vacuum chamber 2. The gas introduced from the gas supply source 18 is hydrogen (H₂) gas or OH group gas. Herein, hydrogen gas is employed.

The motor 7, the high frequency power source 10, the bias power source 12, a waveform generator 13, the evaporation power source 15, the evaporative material feeding system 16, the vacuum pump 17 and the gas supply source 18 are controlled by a controller 20 consisting of a computer. The output of the film thickness monitor 19 is input to the controller 20.

Next, the configuration of the parts of the semiconductor wiring forming system 1 will be described in detail.

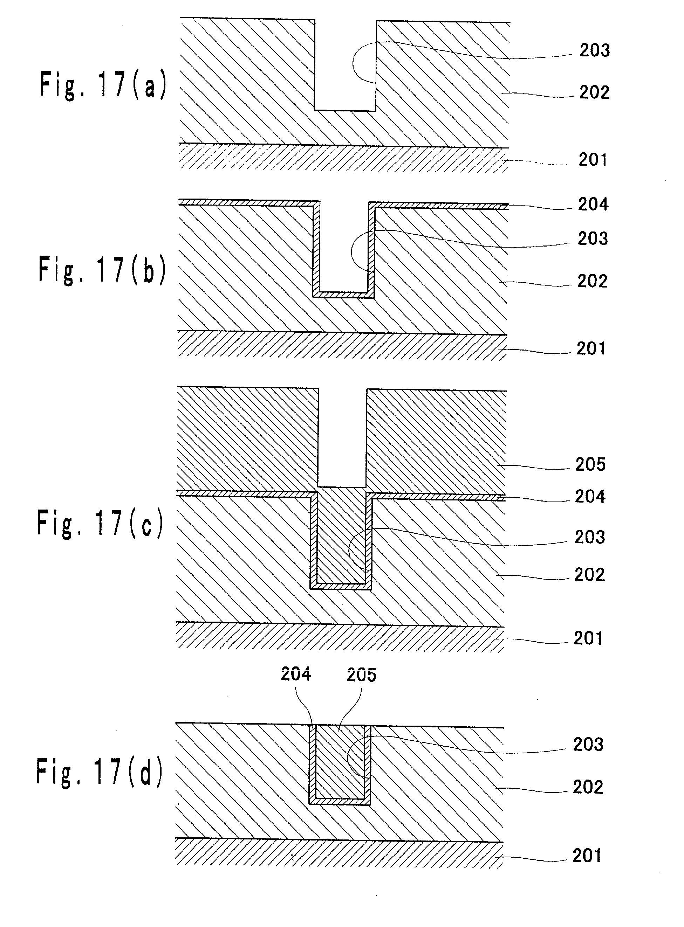

The wafer 201 is finally processed to form a semiconductor device. The wafer 201 of the present embodiment is made of silicon (Si) and an insulating layer 202 made of silicon dioxide (SiO₂) is formed on its surface, as shown in Figure 17(b). Wiring grooves 203 are formed on the surface of the insulating layer 202 and a barrier layer 204 is formed so as to thinly cover the entire surface of the insulating layer in which the wiring grooves 203 are formed. The barrier layer 204 is formed for blocking the dispersion of copper (Cu) over the insulating layer 202 and comprised of TaN, TiN or the like.

In the present embodiment, the high frequency power source 10 outputs a high frequency electric power of 13.56 MHz. A known matching unit is used as the matching unit 9. The matching unit 9 matches the impedance of the load side to the impedance of the power source side, following changes in the impedance between the substrate holder 3 and the vacuum chamber 2. The matching capacitor C blocks a direct current and gives specified fixed capacitance to the impedance of the load side when viewing from the matching unit 9 to expand the applicable range of the matching unit 9. By properly selecting the capacitance of the matching capacitor C, the matching operation of the matching unit 9 can be soundly carried out even if the load, that is, the wafer 201 serving as a substrate and its film depositing condition vary, and as a result, a plasma can be stably generated even at a high degree of vacuum. Herein, the capacitance of the matching capacitor C is the same as that of the capacitor disposed in the matching unit 9, that is, about 1000 pF.

The bias power source unit 11 has the waveform generator 13 and the bias power source 12. The waveform generator 13 generates a voltage signal having a specified waveform and this generated voltage signal is amplified by the bias power source 12 to be output from the output terminal of the bias power source unit 11. As shown in Figure 2, the bias voltage output from the bias power source unit 11 has a rectangular waveform which takes a negative value -Vn during a time period T1 and a positive value +Vp during a time period T2. In other words, the bias voltage is such that a positive rectangular wave pulse having a height of (Vn + Vp), width of T2 and cycle T (= T1 + T2) is superimposed on a negative d.c. bias voltage -Vn. Therefore, the bias power source unit 11 is a kind of d.c. power source system described in Claims. The values +Vp and -Vp are properly selected from the range of from 0 v to 2000 v according to film depositing conditions. The duty factor (T2/T) of the positive rectangular wave pulse is preferably 40 % or less. If it exceeds 40%, the high frequency plasma might be attenuated, leading to a decrease in film deposition efficiency. The frequency (= 1/T) of the positive rectangular wave pulse is preferably within the range of from 1 KHz to 1 GHz. If the frequency is less than 1 KHz, the bias less often takes a positive value so that an electric filed causing dielectric breakdown is generated before neutralizing positive charges which have been captured and accumulated around the wafer 201. On the other hand, if the frequency exceeds 1 GHz, it becomes difficult to adjust the timing for applying the positive rectangular wave pulse.

The evaporation source 4 and the evaporative material feeding system 16 are comprised of an electron beam generator 43 and a rotary-revolutionary multi-point crucible 40, as shown in Figure 4. The rotary-revolutionary multi-point crucible 40 is designed to have a plurality of crucibles 42a to 42d (four crucibles in the present embodiment) which house a specified amount of wiring material (copper in the present embodiment) and rotate respectively while revolving about a common axis of revolution 41. A motor (not shown) serving as a driving source causing the rotation and revolution of the crucibles is connected to the controller 20 shown in Figure 1. The mechanism for the rotation and revolution of the plurality of crucibles 42a to 42d is attained by a known planetary gear train and therefore an explanation for it is omitted herein. The electron beam generator 43 is connected to the evaporation power source 15 shown in Figure 1 and projects an electron beam 44 to one (the crucible 42a in Figure 4) of the four revolving crucibles 42a to 42d which is located at a specified position to evaporate the wiring material stored therein by heating and melting. The provision of such four crucibles 42a to 42d enables continuous feeding of the evaporative material for 24 hours or more.

The film thickness monitor 19 is for monitoring the thickness of a wiring material layer 205 (see Figure 17(c)) to be formed on the wafer 201 mounted on the substrate holder 3 and is comprised of a quartz oscillator. The controller 20 detects the number of vibrations, that is, the oscillation frequency of the quartz oscillator serving as the film thickness monitor 19. According to this arrangement, when the evaporated wiring material deposits on the film thickness monitor 19, the oscillation frequency of the film thickness monitor 19 decreases as the thickness of the deposit increases, so that the thickness of the wiring material layer 205 formed on the wafer 201 can be monitored.

Next, there will be explained the operation of the semiconductor wiring forming system having the configuration described above (semiconductor wiring forming method).

In Figures 1 to 4, the wafer 201 is mounted on the substrate holder 3 within the vacuum chamber 2 and when the semiconductor wiring forming system 1 is activated, the semiconductor wiring forming system 1 automatically performs the following operation, being controlled by the controller 20.

First, the motor 7 is operated to rotate the substrate holder 3, while the vacuum pump 17 is operated to evacuate air from the vacuum chamber 2 so that the vacuum chamber 2 has a specified degree of vacuum. Subsequently, hydrogen gas is introduced into the vacuum chamber 2 from the gas supply source 18. The degree of vacuum herein is 10⁻³ Pa. The hydrogen content of the atmosphere within the vacuum chamber 2 is constantly maintained within the range of from 4 to 20 % by volume, for the reason that where the hydrogen content is 4 % or more, the effective migration effect (described later) can be achieved and hydrogen contents of more than 20 % are undesirable in view of explosion-protection.

Then, the high frequency power source 10 is operated, applying a high frequency voltage between the vacuum chamber 2 and the substrate holder 3, so that a plasma 301 is generated within the vacuum chamber 2. Thereafter, the bias power source unit 11 is operated, applying a bias voltage such as shown in Figure 2 between the vacuum chamber 2 and the substrate holder 3, so that an electric field is generated which is directed from the vacuum chamber 2 to the substrate holder 3 during a time period T1 and directed reversely during a time period T2 that is shorter than the time period T1, such change of the direction being repeated in a cycle T.

Thereafter, the electron beam generator 43 and rotary-revolutionary multi-point crucible 40 which serve as the evaporation source 4 and the evaporative material feeding system 16 are operated such that the electron beam generator 43 projects the electron beam 44 to the wiring material stored in the rotating and revolving crucibles 42a to 42d so that the wiring material evaporates from the crucibles 42a to 42d.

As shown in Figure 3, the distribution of a potential Vp between the evaporation source 4 and the substrate holder 3 during the time period T1 is such that, as the potential Vp approaches to the substrate holder 3 from the evaporation source 4, it increases to a slight positive potential value and is then maintained at a substantially constant value. Then after the potential Vp has reached a point in close proximity to the substrate holder 3, it rapidly drops to a negative potential value. This distribution of the potential Vp is mainly brought about by the self-bias attributable to a high frequency voltage. During the time period T1 in such a situation, the evaporated wiring material in the form of atoms is allowed by the evaporation energy to pass through the plasma 301. While passing through the plasma 301, the wiring material is energized by the plasma 301 and markedly accelerated by the precipitous electric field in the vicinity of the substrate holder 3 so that it bumps against the surface of the wafer 201, adhering to and depositing on the wafer surface. Since the evaporated wiring material is energized by the plasma 301 and markedly accelerated by the electric field mainly constituted by the self-bias at that time, the film to be formed on the wafer 201 becomes dense and good in adhesion. The electric field in which the self-bias and the above bias voltage are superimposed is substantially perpendicular to the surface of the wafer 201 and therefore has a good rectilinear elongation property, so that the wiring grooves 203 formed on the surface of the wafer 201 and having a high aspect ratio are filled with the wiring material in high proportions as shown in Figure 17(c). In addition, the wiring material layer 205 deposited on the wafer 201 becomes more dense and lower in resistance thanks to the migration effect of the hydrogen gas.

With a lapse of time, the thickness of the layer 205 of the wiring material deposited on the wafer 201 increases. Meanwhile, the wiring material is also deposited on the film thickness monitor 19, forming a film. The oscillation frequency of the film thickness monitor 19 decreases with the increased deposit amount of the wiring material, so that the controller 20 changes film deposition parameters according to this. More specifically, the controller 20 changes the rate of film deposition by controlling the evaporation power source 15 according to the decreasing oscillation frequency of the film thickness monitor 19 or changes the condition of film deposition by controlling the high frequency power source 10 and the bias power source unit 11. The optimum film deposition rate and film deposition condition, i.e., the optimum film deposition parameters have been obtained beforehand according to the configuration of the wafer 201, and their characteristic curves which vary relative to a time axis are preset. The reason for this is that the quality of the wiring material layer 205 to be formed on the wafer 201 and the fill factor of the wiring material introduced into the wiring grooves 203 can be optimized only by optimally controlling the film deposition parameters.

Although the impedance between the substrate holder 3 and the vacuum chamber 2 varies during this time period, the provision of the matching capacitor C enables the matching unit 9 to perform proper matching between the impedance of the load side and the impedance of the power source side, so that a plasma can be stably maintained without causing abnormal electric discharging. Further, in the wiring material layer 205 deposited on the wafer 201 during the time period T1, due to the presence of the insulating layer 202, the electric charge of the wiring material ionized is unlikely to be relieved, so that the ions of the wiring material tend to repel one another, causing deposition of the wiring material in conical form. However, during the time period T2, the direction of the electric field in the vicinity of the wafer 201 is reversed and the wiring material which has once deposited is separated from the surface of the wafer 201 (more precisely, the surface of the deposit layer of the electrically discharged wiring material) so that the wiring material again adheres to the surface of the wafer 201 and realigns at that time. Therefore, the wiring material is deposited on the surface of the wafer 201, forming sequentially aligned layers substantially parallel with the surface of the wafer 201. As the result, the wiring material layer 205 has more density.

Since the multi-point crucibles 40 having the four crucibles 42a to 42d is used as the evaporative material feeding system 16, the evaporative material can be stored in the vacuum chamber 2 four times as much as that of the case where a single crucible is used, and as a result, continuous film deposition for 24 hours or more is enabled. It should be noted that continuous operation for 24 hours or more is required in order to obviate the need for halting the semiconductor wiring forming system 1 in the nighttime.

### (Example 1)

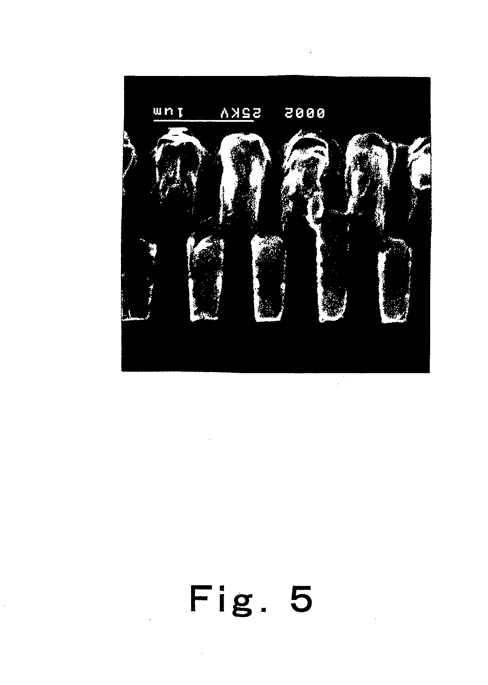

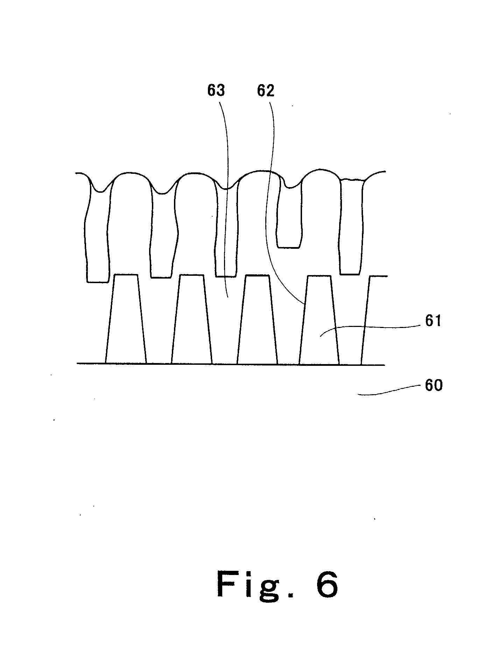

Figure 5 is a cross-sectional photograph showing a filling condition of wiring grooves formed in a wafer, the wiring grooves being filled with a wiring material by a semiconductor wiring forming method according to Example 1. Figure 6 is a sketch of the cross-sectional photograph of Figure 5.

Referring to Figures 5 and 6, in the present example, an insulating layer 61 of silicon dioxide was formed on a wafer 60 made of silicon. Wiring grooves 62 were formed in the insulating layer 61, and accordingly, a barrier layer was omitted. The wiring grooves 62 have a depth of 1µm and width of 0.35 µm. A thin film of wiring material (copper) was formed on the wafer 60 having such wiring grooves 62, using the above-described semiconductor forming system 1. The degree of vacuum (gas pressure) of the vacuum chamber 2 at that time was 10⁻³ Pa. As a result, a thin film 63 made of copper was formed so as to cover the surface of the insulating layer 61 of the wafer 60 having the wiring grooves 62 as shown in Figures 5 and 6. In this case, substantially 100 per cent of the wiring grooves 62 was filled with copper (thin film 63). The copper introduced into the wiring grooves 62 was found to be free from defects such as voids. Conventionally, it was impossible to completely fill 1µm deep, 0.35µm wide wiring grooves with copper, using a dry process.

### (Example 2)

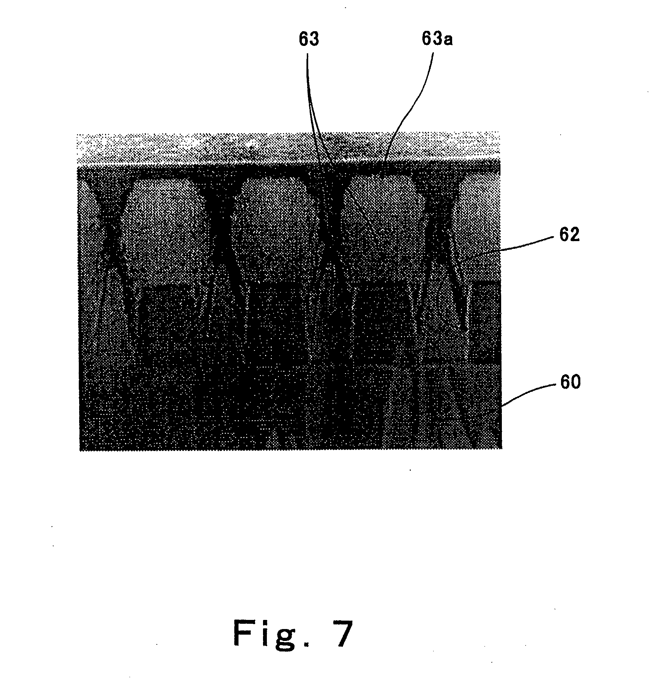

Figure 7 is a cross-sectional photograph showing a polished condition of the surface of a thin film formed on a wafer by a semiconductor wiring forming method according to Example 2.

Referring to Figure 7, in Example 2, a thin film 63 of copper (hereinafter referred to as "copper film") was formed on a wafer having wiring grooves 62 according to the above-described semiconductor wiring forming method and the surface of the copper film (which had not undergone a thermal curing treatment) 63 was polished with a mechanical polishing means for use in CMP. As a result, a flat portion 63a was smoothly formed on the surface of the copper film 63 by polishing, as shown in Figure 7. Compared to the present example, a copper film formed by wet plating is soft. If such a soft cooper film is mechanically polished without undergoing a thermal curing treatment, the projecting part of the copper film surface will collapse onto its recess part, making the film surface coarse so that the film surface cannot be smoothly flattened. To solve this problem, the copper film formed by wet plating is mechanically polished after the thermal curing treatment and the surface planarization treatment by reflow have been applied. In contrast with this, the present example can obviate the need for the thermal curing treatment and the surface planarization treatment.

It is understood from the above result that the semiconductor wiring forming method and system according to the present embodiment is suited for use particularly in the formation of copper wiring for semiconductor devices.

Next, modifications of the first embodiment will be explained below.

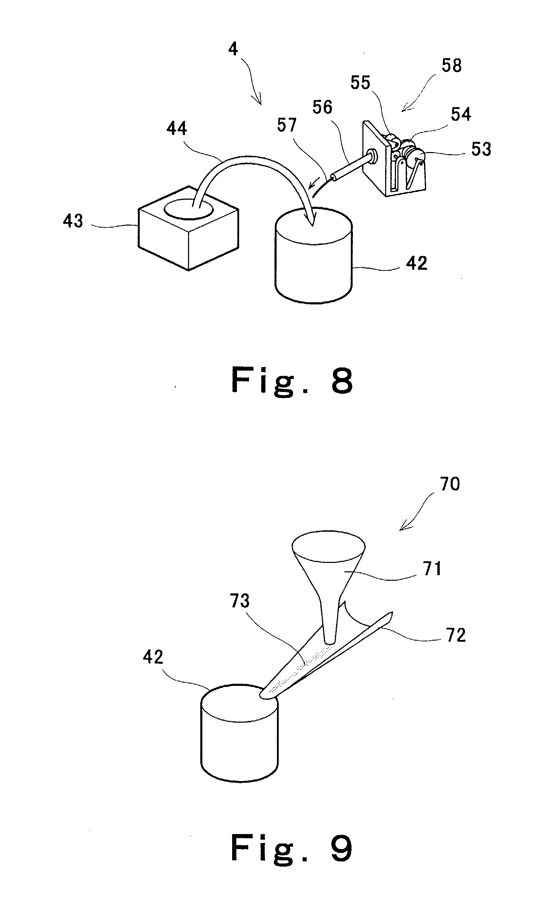

Figure 8 is a perspective view diagrammatically showing a configuration of a first modification of the evaporation source and evaporative material feeding system of the first embodiment.

In the first modification, as shown in Figure 8, an ordinary crucible 42 is used in place of the multi-point crucible 40 described in the foregoing example and an automatic wire feeding system 58 is used as the evaporative material feeding system 16. The automatic wire feeding system 58 is disposed within the vacuum chamber and designed such that a wire 57 made from a wiring material is wound around a reel 53 and drawn out of the reel 53 by a feed roller 55 through a feeder 54, and such that the drawn wire 57 passes through a guide pipe 56 to be fed to the crucible 42 from the leading end of the guide pipe 56. A driving motor (not shown) for the feed roller is connected to the controller 20 shown in Figure 1. In the present modification thus formed, the wiring material in the form of the wire 57 which has been fed from the automatic wire feeding system 58 to the crucible 42 is evaporated by the electron beam 44 projected from the electron beam generator 43. Since the evaporative material is stored in the form of wire within the automatic wire feeding system 58 of the vacuum chamber, the evaporative material can be continuously supplied for 24 hours or more.

Figure 9 is a perspective view diagrammatically showing a configuration of a second modification of the evaporation source and evaporative material feeding system of the first embodiment.

The second modification is similar to the first modification except that an automatic pellet feeding system 70 is used as the evaporative material feeding system 16 in place of the automatic wire feeding system 58, as shown in Figure 9. The automatic pellet feeding system 70 is designed such that pellets 73 made of a wiring material are stored in a hopper 71 and fed to the crucible 42 after passing a guide chute 72. A motor (not shown) for driving the pellet chuting gate of the hopper 71 is connected to the controller 20 shown in Figure 1. With this arrangement, the evaporative material can be continuously fed for 24 hours or more since the evaporative material is stored in the form of pellets within the automatic pellet feeding system 70 disposed in the vacuum chamber.

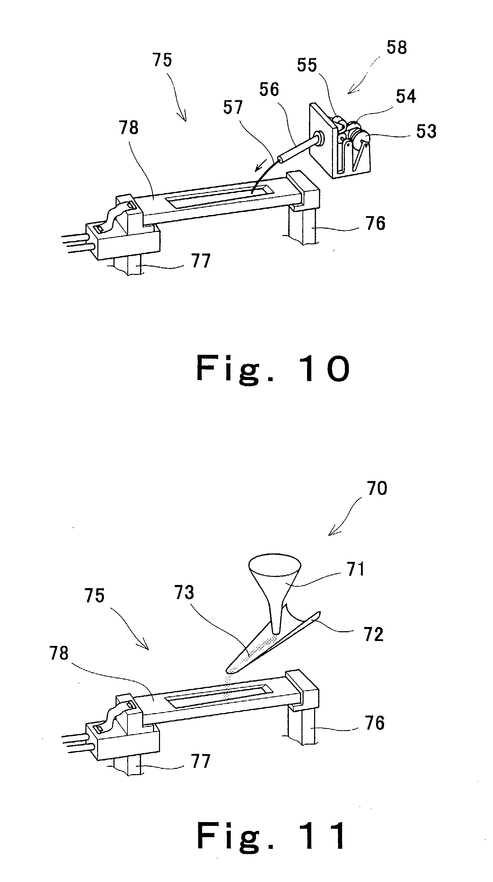

Figure 10 is a perspective view diagrammatically showing a configuration of a third modification of the evaporation source and evaporative material feeding system of the first embodiment.

The third modification is similar to the first modification except that a resistance heating system 75 is used as the evaporation source 4 in place of the electron beam generator 43, as shown in Figure 10. The resistance heating system 75 has a boat 78 that is bridged between the distal ends of a pair of electrodes 76, 77, for storing the evaporative material. The pair of electrodes 76, 77 are connected to the evaporation power source 15 shown in Figure 1. In the present modification thus formed, a current flowing into the boat 78 through the pair of electrodes 76, 77 causes heating and evaporation of the wiring material in the form of the wire 57 which has been fed to the boat 78. With this arrangement, the evaporative material can be continuously supplied for 24 hours or more similarly to the first modification.

Figure 11 is a perspective view diagrammatically showing a configuration of a fourth modification of the evaporation source and evaporative material feeding system of the first embodiment.

The fourth modification is similar to the third modification except that the automatic pellet feeding system 70 is used as the evaporative material feeding system 16 in place of the automatic wire feeding system 58, as shown in Figure 11. With this arrangement, continuous feeding of the evaporative material for 24 hours or more is possible like the third modification.

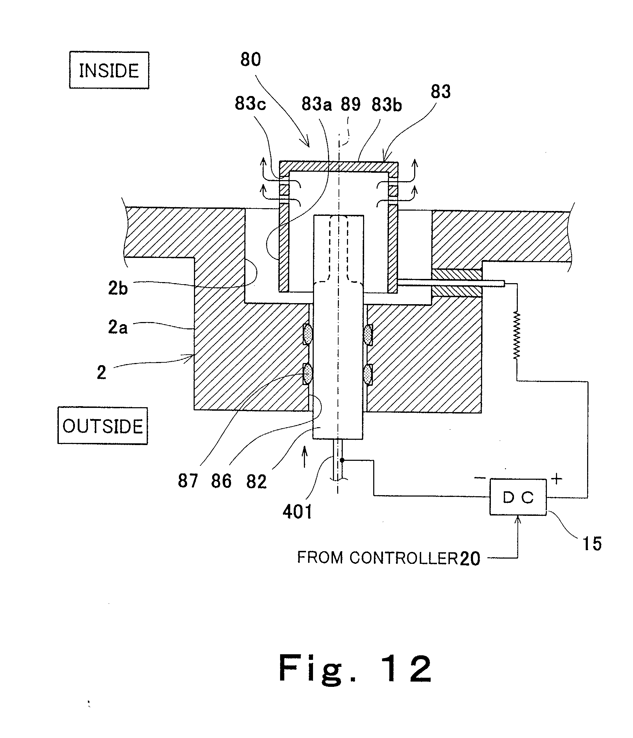

Figure 12 is a sectional view diagrammatically showing a configuration of a fifth modification of the evaporation source and evaporative material feeding system of the first embodiment.

As shown in Figure 12, the present modification uses an arc evaporation source 80 and a cathode conveying mechanism 401 as the evaporation source 4 and the evaporative material feeding system 16, respectively.

The arc evaporation source comprises a cylindrical anode 83 disposed in a recess portion 2b formed in a wall portion 2a of the vacuum chamber 2 and a column-shaped cathode 82 passing a through hole 86 that is defined in the wall portion 2a of the vacuum chamber 2, leading to the recess portion 2b. The anode 83 is closed at its distal end face 83b, with a number of through holes 83c formed in a peripheral surface 83a at the distal end and is made from a heat-resistant conductive material such as tungsten. The cathode 82 is made from the wiring material and its distal end is positioned within the anode 83. The cathode 82 and the anode 83 have a common central axis 89. The cathode 82 is retained and allowed to move back and forth by the cathode conveying mechanism 401 (partially shown in Figure 12). Additionally, sealing members 87 such as O rings are disposed at the inner circumferential surface defining the through hole 86 of the vacuum chamber 2, thereby making the cathode 82 hermetically slidable with respect to the through hole 86. The anode 83 and the cathode 82 are connected to the positive terminal and negative terminal, respectively, of a d.c. arc power source 15 serving as the evaporation power source.

A driving motor (not shown) for the cathode conveying mechanism 401 is connected to the controller 20 shown in Figure 1.

According to the present modification thus arranged, arc discharge is caused between the anode 83 and the cathode 82 by an arc voltage applied by the d.c. arc power source 15, so that the wiring material constituting the cathode 82 evaporates, flowing outwardly from the through hole 83c of the anode 83. And, the cathode 82 is moved forward by the cathode conveying mechanism 401 according to the consumption of the cathode 82 due to the evaporation. Accordingly, continuous feeding of the evaporative material for 24 hours or more is enabled, by making the cathode 82 sufficiently long.

Instead of the rotating and revolving multi-point crucible 40, a resistance heating system including a plurality of similarly rotating and revolving boats may be used as the evaporation source 4 and the evaporative material feeding system 16. It is also possible to employ the known DC sputtering technique. Continuous feeding of the evaporative material for 24 hours or more is possible with these arrangements.

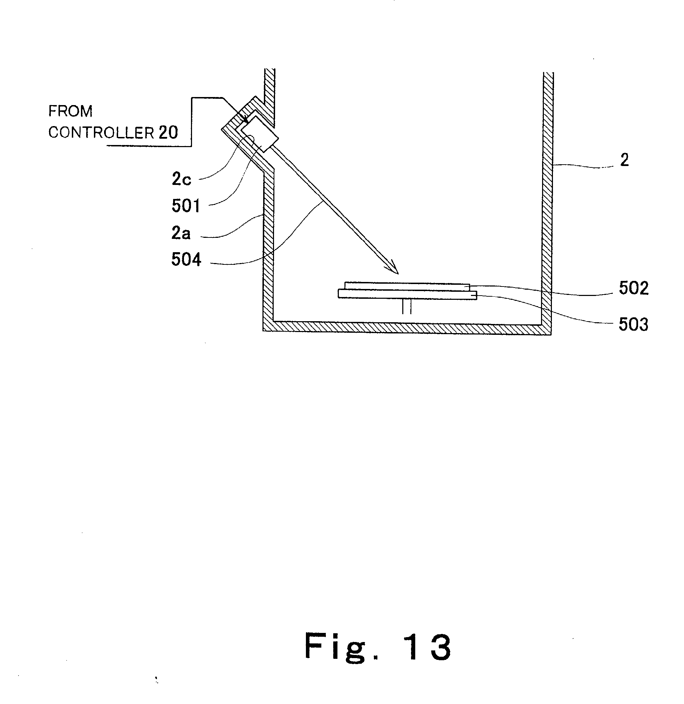

Figure 13 is a pattern diagram diagrammatically showing a configuration of a sixth modification of the evaporation source and evaporative material feeding system of the first embodiment.

In the sixth modification, as shown in Figure 13, a sheet-like target 502 made from an evaporative material is placed on a rotary table 503 installed within the vacuum chamber 2. An ion gun 501 is placed within a recess portion 2c defined by the wall portion 2a of the vacuum chamber 2 and controlled by the controller 20 to project a plus ion beam 504 onto the target 502. The irradiation with the ion beam 504 causes evaporation of the evaporative material from the target 502. In the present modification, the target 502 and the ion gun 501 constitute the evaporation source 4 and evaporative material feeding system 16 shown in Figure 1 and therefore, the evaporative material can be continuously supplied for 24 hours or more by making the size of the target big enough.

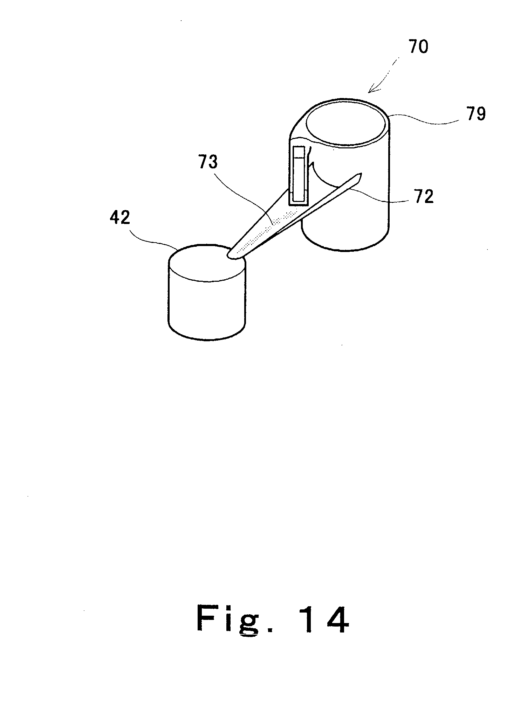

Figure 14 is a perspective view diagrammatically showing a configuration of a seventh modification of the evaporation source and evaporative material feeding system of the first embodiment.

In the seventh modification, an evaporative material quantitative feeding system 79 is provided for the automatic pellet feeding system 70 described in the second modification in place of the hopper, as shown in Figure 14. The evaporative material quantitative feeding system 79 has the same structure as that of ordinary part feeders and stores pellets 73 formed from a wiring material instead of ordinary parts as an object of feeding. As the structure of ordinary part feeders is known and therefore a detailed description of the structure of the evaporative material quantitative feeding system 79 is skipped herein. The evaporative material quantitative feeding system 79 is designed such that the stored pellets are guided to a supply port while being agitated by a vibrator housed in the system 79 and the feed rate of the pellets is controlled by controlling the operating time and vibration level of the vibrator with the controller 20. By virtue of this arrangement, not only continuous feeding of the evaporative material for 24 hours or more but also quantitative supply of the evaporative material becomes possible. As a result, since the thickness of the thin film to be formed on the wafer is substantially determined by the feed rate of the evaporative material in ion plating, the thickness of the thin film can be accurately controlled.

### Second Embodiment

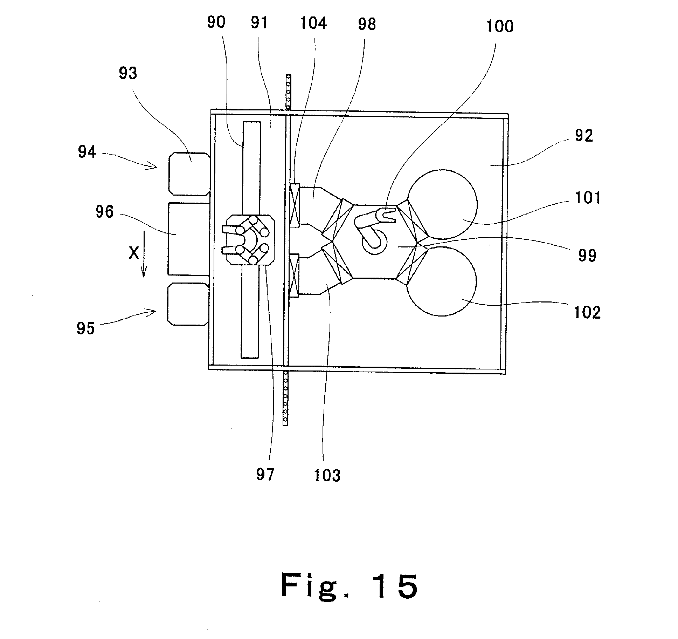

Figure 15 is a plan view diagrammatically showing a configuration of a semiconductor device fabricating system according to a second embodiment of the invention.

As shown in Figure 15, the semiconductor device fabricating system has a vacuum chamber 92 and a clean chamber 91 adjacent to the vacuum chamber 92. In the space that is opposed to the vacuum chamber 92 with the clean chamber 91 between, a first yard 94, an aligner 96 and a second yard 95 are formed so as to be aligned in a direction X in this order alongside the clean chamber 91, and a cassette 93 for accommodating the wafer is designed to sequentially pass through them.

In the clean chamber 91, a rail 90 is disposed so as to extend in the direction X and a clean robot 97 moves on this rail 90. A transfer chamber 99 is disposed within the vacuum chamber 92, and a load lock chamber 98, a barrier chamber 102, a copper film deposition chamber 101 and an unload chamber 103 are respectively connected to the transfer chamber 99 through their respective gates 104. The inside of each of the chambers 98, 99, 101, 102 and 103 is maintained at a specified degree of vacuum. The load lock chamber 98 and the unload chamber 103 are respectively connected to the clean chamber 91 through their respective gates 104. The load lock chamber 98 is positioned upstream the unload chamber 103 when viewing in the direction X. The copper film deposition chamber 101 is comprised of the semiconductor wiring forming system 1 of the first embodiment and a vacuum robot 100 is disposed within the transfer chamber 99.

The operation of the semiconductor device fabricating system of the above-described configuration (semiconductor device fabrication method) will be explained with reference to Figures 15 and 17. Figure 17 is a process cross-sectional view showing a method of forming wiring for a semiconductor device. It should be noted that the following operations are all controlled by a controller (not shown) and automatically carried out.

Referring to Figures 15 and 17, the cassette 93 accommodates the unprocessed wafer 201 to be used in this process and travels from the upstream side when viewing in the direction X. Formed on the unprocessed wafer 201 is an insulating layer 202 made from silicon dioxide as shown in Figure 17(a). Wiring grooves 203 having a high aspect ratio are formed on the surface of the insulating layer 202. The cassette 93 stops when it reaches the first yard 94. Then, the clean robot 97 moves on the rail 90 to a position in front of the cassette 93, takes the unprocessed wafer 201 out of the cassette 93, and then moves to a position in front of the load lock chamber 98. Thereafter, the gate 104 leading to the load lock chamber 98 is opened and the clean robot 97 puts the unprocessed wafer 201 in the load lock chamber 98. The cassette 93 moves to the aligner 96 where it is overhauled and then moves to the second yard 95 to wait therein.

Subsequently, the gate 104 is closed and the load lock chamber 98 is evacuated until it has a specified degree of vacuum. Then, the gate 104 between the load lock chamber 98 and the transfer chamber 99 is opened and closed, and during the opening of the gate 104, the vacuum robot 100 takes the unprocessed wafer 201 out of the load lock chamber 98. Thereafter, the gate 104 between the transfer chamber 99 and the barrier chamber 102 is opened and closed, and during the opening of the gate 104, the vacuum robot 100 puts the unprocessed wafer 201 in the barrier chamber 102.

Then, a barrier layer 204 is formed on the insulating layer 202 of the wafer 201 within the barrier chamber 102. The barrier layer 204 is formed from TaN, TiN or the like with ion plating, sputtering or similar techniques.

The gates 104 between the transfer chamber 99 and the barrier chamber 102 and between the transfer chamber 99 and the copper film deposition chamber 101 are sequentially opened and closed similarly to the above-described gates, and during the opening of the gates 104, the wafer 201 having the barrier layer 204 formed thereon is taken out of the barrier chamber 102 and then put in the copper film deposition chamber 101 by the vacuum robot 100.

Like the first embodiment, a wiring material layer 205 of copper is formed on the barrier layer 204 within the copper film deposition chamber 101, as shown in Figure 17(c).

Thereafter, the gates 104 between the transfer chamber 99 and the copper film deposition chamber 101 and between the transfer chamber 99 and the unload chamber 103 are sequentially opened and closed, and during the opening of the gates 104, the vacuum robot 100 takes the wafer 201 having the wiring material layer 205 formed thereon out of the copper film deposition chamber 101 and then puts it in the unload chamber 103.

After the unload chamber 103 has been brought back to atmospheric pressure, the gate 104 between the unload chamber 103 and the clean chamber 91 is opened and closed, and during the opening of the gate 104, the clean robot 97 takes the wafer 201 having the wiring material layer 205 formed thereon out of the unload chamber 103 and then puts it in the cassette 93 which has been waiting in the second yard 95. Thereafter, the cassette 93 proceeds to the next step. The surface of the wafer 201 having the wiring material layer 205 formed thereon is polished by CMP, and as shown in Figure 17(d), a wire 205 made of copper is embedded, in the wiring grooves 203 having a high aspect ratio and formed in the insulating layer 202. Since the wire 205 is hard enough to undergo CMP, the thermal curing treatment and the surface planarization treatment can be obviated at that time.

As described earlier, according to the present embodiment, a semiconductor device including copper wiring embedded in wiring grooves having a high aspect ratio can be properly fabricated.

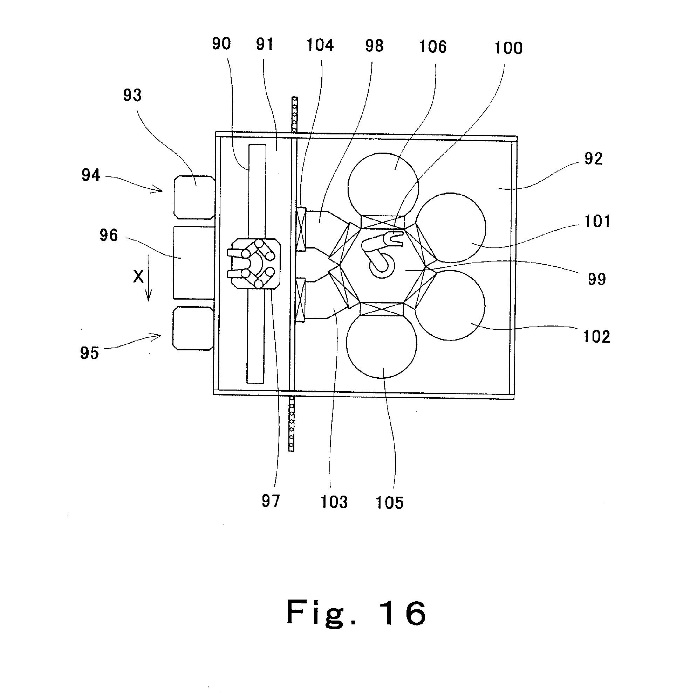

Next, a modification of the second embodiment will be described. Figure 16 is a plan view diagrammatically showing a configuration of a modification of the second embodiment.

Referring to Figures 16 and 17, in the present modification, an etching chamber 105 and a thermal treatment chamber 106 are further connected to the transfer chamber 99 through their respective gates 104. The thermal treatment chamber 106 is comprised of a reflow chamber or anneal chamber capable of letting nitrogen (N₂) or argon (Ar) therein and functions to remelt or anneal the wiring material layer 205 which has been formed from copper in the copper film deposition layer 101, whereby the residual stress of the layer 205 is eliminated or alleviated. Accordingly, this thermal treatment is different from the thermal curing treatment and the surface planarization treatment which are applied to copper wiring in wet plating. The etching chamber 105 is comprised of an etching chamber capable of letting chlorine (Cl₂) gas therein and functions to remove part of the wiring material of the wiring material layer 205 formed on the barrier layer 204, the part adhering to the inlets of the wiring grooves 203. In the present modification thus formed, the vacuum robot 100 makes the wafer 201 having the wiring material layer 205 formed thereon reciprocate a plurality of times between the copper film deposition chamber 101 and the etching chamber 105 and then pass through the thermal treatment chamber 106. Thereafter, the vacuum robot 100 puts the wafer 201 in the unload chamber 103. With this arrangement, even if the wiring material 205 is likely to adhere to the inlets of the wiring grooves 203, the wiring material layer 205 can be formed by the copper film deposition chamber 101 while removing the specified part of the wiring material 205 by the etching chamber 105, so that the wiring grooves having a high aspect ratio can be filled with the wiring material 205 at a high filling factor. In addition, the wiring material 205 formed on the wafer is reduced in internal stress by a thermal treatment applied by the thermal treatment chamber 106, so that improved reliability can be achieved.

While the etching chamber 105 is provided for the present modification, this may be eliminated and the removal of the wiring material 205 adhering to the inlets of the wiring grooves 203 may be carried out by reverse sputtering in the presence of argon gas within the copper film deposition chamber 101. With this arrangement, formation of the wiring material layer 205 and removal of specified part of it can be carried out within the same chamber 101, so that the configuration of the semiconductor device fabricating system can be simplified.

### Third Embodiment

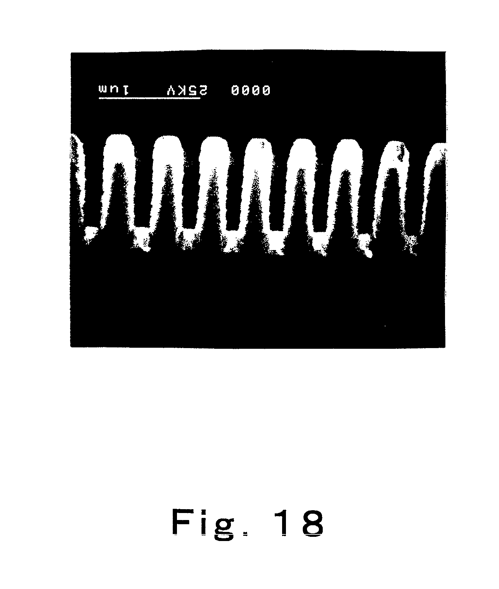

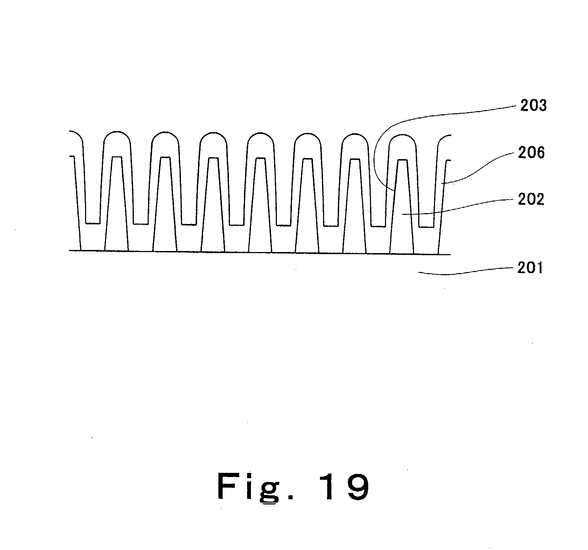

Figure 18 is a cross-sectional photograph showing the coverage of a seed film formed on a wafer by a semiconductor wiring forming method according to a third embodiment of the invention. Figure 19 is a sketch of the photograph of Figure 18.

In the third embodiment, a barrier layer and a seed film made of copper are laminated on a wafer, using the semiconductor wiring forming system of the first embodiment, and then, copper wiring is formed on the seed film by the ordinary wet plating.

Referring to Figure 1, in the present embodiment, since a cloud of plasma 301 is positioned so as to wrap the surface of the wafer 201 when forming the barrier layer and the seed film by the semiconductor wiring forming system 1, the coverage of the evaporative material with respect to the wafer surface becomes good. Therefore, the barrier layer and seed film 206 formed from the evaporative material are good in storage coverage (side coverage and bottom coverage within the wiring grooves 203) as seen from Figures 18 and 19. As a result, the copper wiring formed by the wet plating has good step coverage and generation of voids in the copper wiring is alleviated. It should be noted that the barrier layer is not in the photograph of Figure 18 and therefore excluded in Figure 19.

In the present embodiment, since the barrier layer and seed film 206 formed by the semiconductor wiring forming system 1 of the first embodiment are dense and hard for the reason explained in the first embodiment, the copper of the seed film 206 is unlikely to disperse in the barrier layer and the copper dispersion blocking performance of the barrier layer is improved. By virtue of these effects in combination, the thickness of the barrier layer can be reduced, compared to the prior art. Actually, the thickness of an ordinary barrier layer is 300 to 500 angstrom, whereas a thickness of 150 to 200 angstrom was found to be enough for the barrier layer of the present embodiment when TaN was used as the material of the barrier layer. The thickness of the barrier layer and the seed layer 206 in total was found to be 1500 to 2000 angstrom. In the third embodiment, wiring resistance can be reduced to a degree corresponding to the reduction in the thickness of the barrier layer.

### Fourth Embodiment

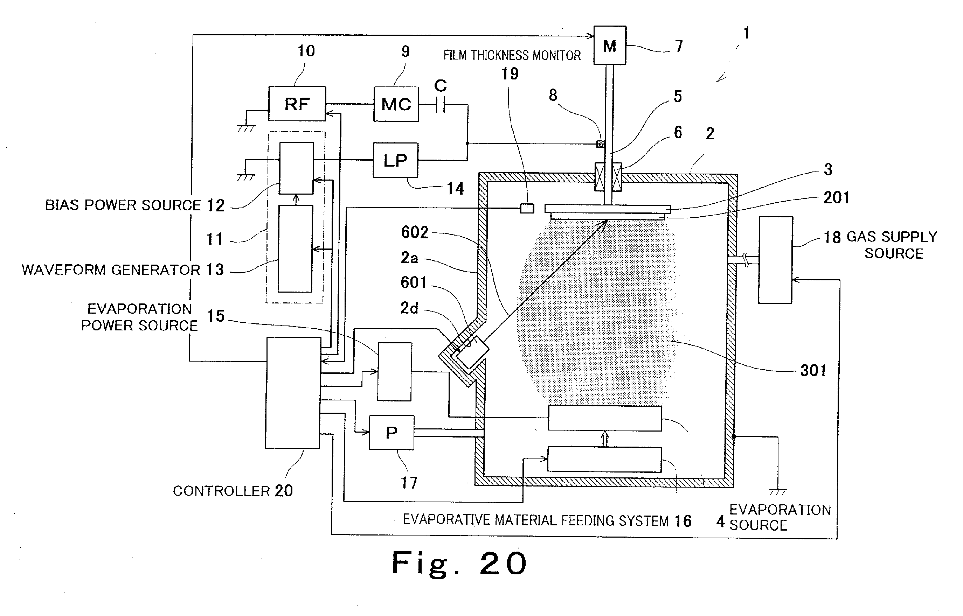

Figure 20 is a pattern diagram showing a configuration of a semiconductor wiring forming system according to a fourth embodiment of the invention. In Figure 20, identical or corresponding parts are indicated with the same reference numerals as in Figure 1.

As shown in Figure 20, the fourth embodiment has the same configuration as in Figure 1 except that an ion gun 601 serving as energy beam projecting means is disposed in a recess portion 2d of the wall portion 2a of the vacuum chamber 2 and controlled by the controller 20 so as to project a plus ion beam (energy beam) 602 onto the wafer 201 held by the substrate holder 3. By the irradiation with the ion beam 602, the energy of the wiring material deposited on the wafer 201 is increased and the molecules of the wiring material are aligned without gaps, so that the wiring material layer becomes further dense.

As the energy beam projecting means, a laser for projecting a laser beam as an energy beam may be used in place of the ion gun. As such a laser, there may be used excimer lasers, YAG harmonic lasers, short-wavelength lasers or the like.

Although the bias power source unit 11 is used for superimposing a bias voltage on a high frequency voltage in the foregoing first and fourth embodiments, it may be omitted. Even if the bias power source unit 11 is excluded, the rectilinear elongation property of the wiring material in the form of energized atoms is increased and the density of the wiring material layer to be formed on the wafer is improved owing to the acceleration effect of the self bias electric field generated by the high frequency voltage.

The film thickness monitor 19 of the first embodiment may be designed to detect the resistance or dielectric constant of the wiring material layer to be formed on the wafer 201.

The first embodiment may be modified such that a gas containing an OH group may be supplied to the vacuum chamber 2 instead of hydrogen gas.

As these embodiments may be embodied in several forms without departing from the spirit of essential characteristics thereof, the present embodiments are therefore illustrative and not restrictive, since the scope of the invention is defined by the appended claims rather than by the description preceding them, and all changes that fall within metes and bounds of the claims, or equivalence of such metes and bounds thereof are therefore intended to be embraced by the claims.

## Claims

1. A semiconductor wiring forming system comprising:
a vacuum chamber the inside of which can be maintained in a substantially vacuum condition;
a substrate holder disposed in the vacuum chamber, for holding a wafer on which a semiconductor wiring film is to be formed;
an evaporation source disposed in the vacuum chamber, for evaporating the material of the semiconductor wiring film; and
a high frequency power source for supplying a high frequency electric power for generating a plasma in the vacuum chamber, making use of the substrate holder as an electrode.

2. The semiconductor wiring forming system according to claim 1, further comprising means for supplying a gas containing hydrogen or an OH group to the vacuum chamber.

3. The semiconductor wiring forming system according to claim 1, further comprising a d.c. power source for generating a d.c. electric field in the vacuum chamber, making use of the substrate holder as a negative electrode.

4. The semiconductor wiring forming system according to claim 3, further comprising controlling means for controlling the forming condition of the semiconductor wiring film to be formed on the wafer, based on the result of monitoring the depositing condition of the semiconductor wiring film.

5. The semiconductor wiring forming system according to claim 4,
wherein the forming condition of the semiconductor wiring film is at least one of the deposition rate of the semiconductor wiring film, the level of the high frequency electric power and the magnitude of the d.c. electric field.

6. The semiconductor wiring forming system according to claim 3, further comprising potential changing means for temporarily changing the potential of the substrate holder to a positive potential.

7. The semiconductor wiring forming system according to claim 6,
wherein the potential changing means superimposes a pulse on the d.c. electric field, the pulse reversing the direction of the d.c. electric field in a predetermined cycle over a specified period of time.

8. The semiconductor wiring forming system according to claim 1, further comprising semiconductor wiring film material feeding means capable of continuously feeding the semiconductor wiring film material for 24 hours or more, the semiconductor wiring film material being evaporated from the evaporation source.

9. The semiconductor wiring forming system according to claim 1,
wherein the evaporation source and the semiconductor wiring film material feeding means are comprised of at least one of or a combination of techniques which are (1) a technique utilizing electron beam heating and a rotary-revolutionary multi-point crucible in combination; (2) a technique utilizing electron beam heating and an automatic wire-like semiconductor wiring film material feeding mechanism in combination; (3) a technique utilizing electron beam heating and an automatic pellet-like semiconductor wiring film material feeding mechanism in combination; (4) a technique utilizing resistive heating and a rotary-revolutionary multi-point boat in combination; (5) a technique utilizing resistive heating and an automatic wire-like semiconductor wiring film material feeding mechanism in combination; (6) a technique utilizing resistive heating and an automatic pellet-like semiconductor wiring film material feeding mechanism in combination; (7) arcing with an automatic semiconductor wiring film material feeding mechanism; (8) ion beam irradiation; and (9) DC spattering.

10. The semiconductor wiring forming system according to claim 1, comprising semiconductor wiring film material feeding means capable of quantitatively feeding the semiconductor wiring film material evaporated from the evaporation source.

11. The semiconductor wiring forming system according to claim 1,
wherein the gas pressure of the substantially vacuum condition is in the order of 10⁻³ Pa.

12. The semiconductor wiring forming system according to claim 1,
wherein a matching unit for matching the impedance of a power source side to the impedance of a load side and a capacitor having specified capacitance are inserted in a circuit for supplying the high frequency electric power such that they are connected in series with the other electrode for supplying the high frequency electric power and the substrate holder.

13. The semiconductor wiring forming system according to claim 1, further comprising energy beam projecting means for projecting an energy beam onto the semiconductor wiring film to be formed on the surface of the wafer held by the substrate holder.

14. The semiconductor wiring forming system according to claim 1,
wherein the other electrode for supplying the high frequency electric power is the vacuum chamber comprised of a conductive element.

15. The semiconductor wiring forming system according to claim 1,
wherein wiring grooves are formed on the surface of the wafer and the semiconductor wiring film material is copper.

16. A semiconductor device fabricating system at least comprising:
a transfer chamber and a load lock chamber, a barrier chamber, a copper film deposition chamber and an unload chamber which are respectively connected to the transfer chamber through gates;
wherein a wafer placed in the load lock chamber is sequentially moved to the barrier chamber and the copper deposition film chamber by transfer means disposed in the transfer chamber while the gates are opened and closed, so that specified treatments are applied to the wafer, and thereafter, the wafer is placed in the unload chamber; and
wherein the copper film deposition chamber is comprised of the semiconductor wiring forming system of claim 15.

17. A semiconductor wiring forming method, wherein
a vacuum chamber the inside of which can be maintained in a substantially vacuum condition is used;
a wafer on which a semiconductor wiring film is to be formed is held by a wafer substrate holder disposed in the vacuum chamber;
the material of the semiconductor wiring film is evaporated by an evaporation source disposed in the vacuum chamber; and
a high frequency electric power for generating a plasma in the vacuum chamber, making use of the substrate holder as an electrode, is supplied from a high frequency power source.

18. The semiconductor wiring forming method according to claim 17,
wherein a gas containing hydrogen or an OH group is supplied to the vacuum chamber.

19. The semiconductor wiring forming method according to claim 18,
wherein the hydrogen content of the atmosphere within the vacuum chamber is 4 to 20 % by volume.

20. The semiconductor wiring forming method according to claim 17,
wherein a d.c. power source generates a d.c. electric field within the vacuum chamber, making use of the substrate holder as a negative electrode.

21. The semiconductor wiring forming method according to claim 20,
wherein the forming condition of the semiconductor wiring film to be formed on the wafer is controlled based on the result of monitoring the depositing condition of the semiconductor wiring film.

22. The semiconductor wiring forming method according to claim 21,
wherein the forming condition of the semiconductor wiring film is at least one of the deposition rate of the semiconductor wiring film, the level of the high frequency electric power and the magnitude of the d.c. electric field.

23. The semiconductor wiring forming method according to claim 20,
wherein the potential of the substrate holder is temporarily changed to a positive potential.

24. The semiconductor wiring forming method according to claim 23,
wherein the potential of the substrate holder is temporarily changed to a positive potential by superimposing a pulse on the d.c. electric field, the pulse reversing the direction of the d.c. electric field in a predetermined cycle over a specified period of time.

25. The semiconductor wiring forming method according to claim 17,
wherein the semiconductor wiring film material evaporated from the evaporation source is supplied by semiconductor wiring film material feeding means capable of continuously feeding the semiconductor wiring film material for 24 hours or more.

26. The semiconductor wiring forming method according to claim 17,
wherein the evaporation source and the semiconductor wiring film material feeding means are comprised of at least one of or a combination of techniques which are (1) a technique utilizing electron beam heating and a rotary-revolutionary multi-point crucible in combination; (2) a technique utilizing electron beam heating and an automatic wire-like semiconductor wiring film material feeding mechanism in combination; (3) a technique utilizing electron beam heating and an automatic pellet-like semiconductor wiring film material feeding mechanism in combination; (4) a technique utilizing resistive heating and a rotary-revolutionary multi-point boat in combination; (5) a technique utilizing resistive heating and an automatic wire-like semiconductor wiring film material feeding mechanism in combination; (6) a technique utilizing resistive heating and an automatic pellet-like semiconductor wiring film material feeding mechanism in combination; (7) arcing with an automatic semiconductor wiring film material feeding mechanism; (8) ion beam irradiation; and (9) DC spattering.

27. The semiconductor wiring forming method according to claim 17,
wherein the semiconductor wiring film material evaporated from the evaporation source is quantitatively supplied.

28. The semiconductor wiring forming method according to claim 17,
wherein the gas pressure of the substantially vacuum condition is in the order of 10⁻³ Pa.

29. The semiconductor wiring forming method according to claim 17,
wherein a matching unit for matching the impedance of a power source side to the impedance of a load side and a capacitor having specified capacitance are inserted in a circuit for supplying the high frequency electric power such that they are connected in series with the other electrode for supplying the high frequency electric power and the substrate holder.

30. The semiconductor wiring forming method according to claim 17,
wherein an energy beam is projected onto the semiconductor wiring film to be formed on the surface of the wafer held by the substrate holder.

31. The semiconductor wiring forming method according to claim 17,
wherein the other electrode for supplying the high frequency electric power is the vacuum chamber comprised of a conductive element.

32. The semiconductor wiring forming method according to claim 17,
wherein wiring grooves are formed on the surface of the wafer and the semiconductor wiring film material is copper.

33. A semiconductor wiring forming method comprising the steps of:
forming a seed film on a wafer by the semiconductor wiring forming method of claim 17; and
forming a semiconductor wiring film on the wafer from the seed film by wet plating.

34. The semiconductor wiring forming method according to claim 33,
wherein a barrier layer is formed as an underlayer for the seed film and copper is used as the material of the seed film and the semiconductor wiring film.

35. A semiconductor device fabricating method,
wherein at least a transfer chamber and a load lock chamber, a barrier chamber, a copper film deposition chamber and an unload chamber which are respectively connected to the transfer chamber through gates are used;
which includes the step of placing a wafer in the unload chamber after the wafer placed in the load lock chamber has been transferred sequentially to the barrier chamber and the copper film deposition chamber by transfer means disposed in the transfer chamber, with the gates being opened and closed to apply specified treatments to the wafer, and
wherein the specified treatment carried out in the copper film deposition chamber is constituted by the semiconductor wiring forming method of claim 32.

36. A wafer wherein grooves having a width of about 0.35µm and depth of about 1 µm are formed on the surface of the wafer or on the surface of a layer formed on the wafer and substantially 100 per cent of the grooves is filled with a wiring film material comprised of copper by a dry process.

37. Apparatus (1) for forming wiring on a semiconductor wafer (201), the apparatus comprising a vacuum chamber (2); a support (3) for supporting such a semiconductor wafer in the vacuum chamber; a source (4; 40; 42; 75; 80; 502) of wiring material; and a high frequency power source (10) which can be supplied to said support for improving the distribution of wiring material on the wafer when in use.

38. A method of wiring forming on a semi-conductor wafer (201) supported on a support (3) in a vacuum chamber (2); the method comprising supplying high frequency power to said support to improve the distribution of wiring material from a writing material source (4; 40; 42; 75; 80; 502) on such a wafer.
